# EUROPEAN PATENT SPECIFICATION

(11) **EP 1 138 058 B1**
(45) Date of publication and mention of the grant of the patent: **18.05.2011**
(21) Application number: 00938722.6
(22) Date of filing: 31.05.2000
(51) Int. Cl.: H01L 29/49, H01L 21/336

(54) **METHOD OF MANUFACTURING A SEMICONDUCTOR DEVICE HAVING A GATE WITH A VARYING WORK FUNCTION**
VERFAHREN ZUR HERSTELLUNG EINES HALBLEITERBAUELEMENTS MIT GATE MIT EINER VARIIERNDEN AUSTRITTSARBEIT
PROCÉDÉ DE FABRICATION D'UN DISPOSITIF SEMI-CONDUCTEUR À TRAVAIL D'EXTRACTION VARIABLE

(30) Priority: 11.06.1999 EP 99201869
(43) Date of publication of application: 04.10.2001
(73) Proprietor: NXP B.V., 5656 AG Eindhoven (NL)
(72) Inventor: STOLK, Peter, A., NL-5656 AA Eindhoven (NL); PONOMAREV, Youri, NL-5656 AA Eindhoven (NL)
(74) Representative: Schouten, Marcus Maria
(86) International application number: PCT/EP2000/005012
(87) International publication number: WO 2000/077828

(56) References cited:
- EP-A- 0 856 892
- US-A- 5 538 913
- US-A- 5 600 168
- US-A- 5 804 856
- US-A- 6 051 470
- PATENT ABSTRACTS OF JAPAN vol. 1998, no. 03, 27 February 1998 (1998-02-27) & JP 09 293862 A (SONY CORP), 11 November 1997 (1997-11-11) -& US 6 001 698 A 14 December 1999 (1999-12-14)

## Description

The invention rotates to a method of manufacturing a semiconductor device comprising a semiconductor body which is provided at a surface with an active region of a first conductivity-type, which active region is provided with a transistor having a gate insulated from a channel provided at the surface of the semiconductor body by a gate dielectric, the channel having a length over which it extends between a source zone and a drain zone of a second conductivity type provided in the semiconductor body, the gate comprising a central portion and side end portions positioned along either side of the central portion, which central portion and side end portions are in contact with the gate dielectric and jointly establich a work function of the gate varying across the length of the channel.

Such a method is known from US-A-5,466,958. In the known method, a first layer of polycrystalline silicon is deposited on a gate oxide layer present on the surface of the semiconductor body, which first layer of polycrystalline silicon is patterned by means of a lithographic technique and an etching treatment so as to form the central portion of the gate. A second layer of polycrystalline of silicon is deposited and anisotropically etched so as to provide the central portion of the gate with side walls, which represent the side end portions of the gate.

Also a method is known from US-A-5,538,913. In this method, an opening over the surface of the substrate is formed in a shielding layer that covers the active region of a MOS transistor to be formed. The opening has two sidewalls that generally define the channel region for the MOS transistor. A gate insulation layer is then formed over the surface of the substrate within the confinement of the opening. Conducting sidewall spacers are then formed over the sidewalls of the opening. The shielding layer and conducting sidewall spacers are then utilized as implantation mask for forming the channel region of the transistor. Next a conducting layer is deposited in the space as confined within the conducting sidewall spacers to form a gate consisting of a central portion (the conducting layer) and side end portions (the conducting sidewall spacers). For the formation of a heavily doped region in the active region, the gate and field oxide layer are used as the implantation mask. The lightly-doped region completely overlaps the gate, and extends into the drain and source regions of the MOS transistor.

Moreover, a method is known from EP-A-0 856 892. In EP-A-0 856 892 a MOSFET device structure and its manufacturing method are disclosed. The embodiments of the MOSFET device structure are each designed with a gate electrode structure with varying work function along the channel length. The MOSFET structure is manufactured in such a way that in an earlier step the gate structure is created and later the gate structure with its varying work function is used as an implantation mask for a low-concentration impurity layer and a high-concentration impurity layer of the source/drain regions.

From JP 09 293862 A (and Patents Abstracts of Japan, vol. 1998, no. 3,27-2-1998) a method is known for the manufacture of MOS and CMOS transistors which can eliminate disadvantages caused by mutual diffusion.

A disadvantage of some the known methods is that the gate cannot be built up from the central portion and the side end portions in a length equal to the minimum feature size obtainable by means of a lithographic step, but is inevitably built up so as to have a length larger than the minimum lithographic feature size.

It is an object of the invention to provide an alternative method of manufacturing a semiconductor device of the kind mentioned in the opening paragraph, which enables the formation of the gate in a length that is smaller than the length obtained in the known method and that may even be approximately equal to the minimum feature size obtainable by means of a lithographic step in special cases.

According to the invention, this object is achieved by a method in accordance with claim 1.

As the gate is built up from the central portion and the side end portions in a length defined by the width of the opening in the dielectric layer, which opening is litographically provided at an earlier stage of the process, the gate can be formed in a length that is smaller than the length obtained in the known method and that may even be approximately equal to the minimum feature size obtainable by means of a lithographic step in special cases.

The dielectric layer provided with the opening may be obtained by depositing the dielectric layer and subsequently etching it while using a mask exposing the area of the planned gate. In this way, the formation of the source zone and the drain zone needs to be carried out after the formation of the gate. The gate will hence be subjected to temperatures as high as approximately 1000°C, which are needed to electrically activate the as-implanted atoms and to repair the implantation damage brought about to the lattice of the semiconductor body. Exposure of the gate to such high temperatures imposes serious constraints on the choice of process-compatible gate materials. A preferred embodiment of the method in accordance with the invention is therefore characterized in that, prior to the application of the dielectric layer, a patterned layer is applied at the area of the planned gate, after which the source zone and the drain zone of the second conductivity type are formed in the semiconductor body while using the patterned layer as a mask, after which the dielectric layer is provided in such a way, that the thickness of the dielectric layer next to the patterned layer is substantially equal to or larger than the height of the patterned layer, which dielectric layer is removed over part of its thickness by means of a material removing treatment until the patterned layer is exposed, which patterned layer is removed, thereby forming the opening in the dielectric layer at the area of the planned gate.

MOPS transistors with channel lengths sealed down to deep sub-micrometer levels may sutler from so-called short-channel effects. One of these short-channel effects is known as short-channel threshold-voltage reduction. Experimentally it is observed that, as the channel length decreases to less than about 1 µm, the threshold voltage of a MOS transistor ultimately drops to a value bellow the long-channel value, which effect is referred to as short-channel threshold voltage reduction. The fraction of the depletion charge within the channel region, which is induced by the source zone and the drain zone, is insignificant for long-channel transistors, but becomes increasingly significant for short-channel transistors with the channel length approaching the sum of the widths of the depletion regions of the source zone and the drain zone. Consequently, less charge is needed to cause inversion, and the threshold voltage is reduced. In other words, the switching of short-channel transistors becomes less controlled by the gate.

Up to now, the short-channel threshold-voltage reduction could be kept within acceptable limits by reducing the junction depth of the source zone and the drain zone and increasing the channel dopant level. However, for MOS transistors with channel lengths approaching 0.1 µm this approach no longer works, because the suppression of the short-channel threshold-voltage reduction requires too high dopant levels in the channel which leads to junction breakdown. An alternative approach for suppressing the short-channel threshold-voltage reduction is based on lateral grading of the work function of the gate. Hence, in order to compensate for a threshold-voltage reduction owing to short-channel effects, it is advantageous to vary the work function of the side end portions of the gate relative to the work function of the central portion of the gate.

One method in the prior art is characterised in that, prior to the application of the second conductive layer, the first conductive layer is anisotropically etched until the gate dielectric at the area of the central portion of the gate to be provided at a later stage is exposed, thereby providing the side end portions of the gate, after which the second conductive layer is applied, thereby filling the opening and providing the central portion of the gate. In order to compensate for a short-channel threshold-voltage reduction, the first conductive layer is advantageously applied with a Fermi level lower than that of the second conductive layer for an n-channel transistor, whereas the first conductive layer is advantageously applied with a Fermi level higher than that of the second conductive layer for a p-chansel transistor. It will be evident that several combinations of conductive materials, which may be selected from, for example, metals and semiconductor materials, are possible for the first conductive layer and the second conductive layer, each one of these combinations usually satisfying only one of the above-mentioned conditions, that is to say the condition for the n-channel MOS transistor or the condition for the p-channels MOS transistor. It is therefore advantageous to apply a layer of a semiconductor material of the second conductivity type as the second conductive layer, the semiconductor material having a band gap, and to apply a layer of a conductive material having a Fermi level positioned approximately halfway the band gap of the semiconductor material as the first conductive layer. This enables both a p-channel transistor and an n-channel transistor to be manufactured using one common first conductive layer, which reduces the number of masks required for the manufacture of a semiconductor device comprising an n-channel transistor as well was a p-channel transistor by two. Obviously, several combinations of a semiconductor material and a conductive material are possible, which satisfy the condition that the Fermi level of the conductive material is positioned approximately halfway the band gap of the semiconductor material. However, in order to increase the compatibility with standard CMOS processing, it is advantageous to apply polycrystalline silicon or amorphous silicon as the semiconductor material of the second conductive layer and a material selected from the group comprising titanium nitride, tungsten and tantalum disilicide as the conductive material of the first conductive layer. According to the method of the invention, a layer of a semiconductor material is applied as the first conductive layer, which layer is implanted with impurities of the second conductivity type substantially perpendicularly to the surface of the semiconductor body, thereby providing the central portion and the side end portions of the gate, which central portion is relatively heavily doped compared to the side end portions, after which the second conductive layer is applied, thus filling the opening. An appropriate selection of implantation conditions enables the central portion of the gate to be doped with impurities, while the side end portions of the gate remain at least substantially free from impurities.

In order to increase the compatibility with standard CMOS processing, the layer of semiconductor material is advantageously applied by depositing a layer comprising silicon such as polycrystalline silicon, amorphous silicon or polycrystalline SiₓGe₁₋ₓ, with x representing the fraction of silicon lying in the range between 0 and 1. The second conductive layer may be applied as a layer of a semiconductor material of the second conductivity type, which layer may comprise silicon, such as polycrystalline silicon, amorphous silicon or polycrystalline SiₓGe₁₋ₓ. However, the second conductive layer is advantageously applied as a layer comprising a metal. This enables both a p-channel transistor and an n-channel transistor to be manufactured using one common second conductive layer, which reduces the number of masks required for the manufacture of a semiconductor device comprising an n-channel transistor as well as a p-channel transistor by two. Metals intrinsically have a relatively low resistance compared to silicon and do not suffer from detrimental depletion effects. In this respect, a low-resistance metal such as aluminum, tungsten, copper or molybdenum can be advantageously applied. If a metal is used, the second conductive layer is preferably applied as a double-layer consisting of a layer comprising the mental on top of a layer acting as adhesion layer and/or barrier layer. In this respect Ti may be applied as the adhesion layer and TiN or TiW as the barrier layer.

These and other aspects of the invention will be apparent from and be elucidated with reference to the embodiments described hereinafter and shown in the drawings. In the drawings:
Figs. 1. to 11 show in diagrammatic cross-sectional views successive stages in the manufacture of a semiconductor device comprising a transistor of which only figures 1-8 are in accordance with the present invention, figures 9 -11 illustrating a method not in accordance with the present invention, using a first embodiment of the method in accordance with the invention.
Figs. 12 to 15 show in diagrammatic cross-sectional views successive stages in the manufacture of a semiconductor device comprising a transistor, using an embodiment of the method in accordance with the invention.

Although the invention is illustrated hereinafter on the basis of a MOS transistor, it will be evident to those skilled in the art that the invention may also be advantageously applied in the manufacture of a MOS transistor with a floating gate, also referred to as floating gate transistor, or of CMOS and BICMOS integrated circuits known per se.

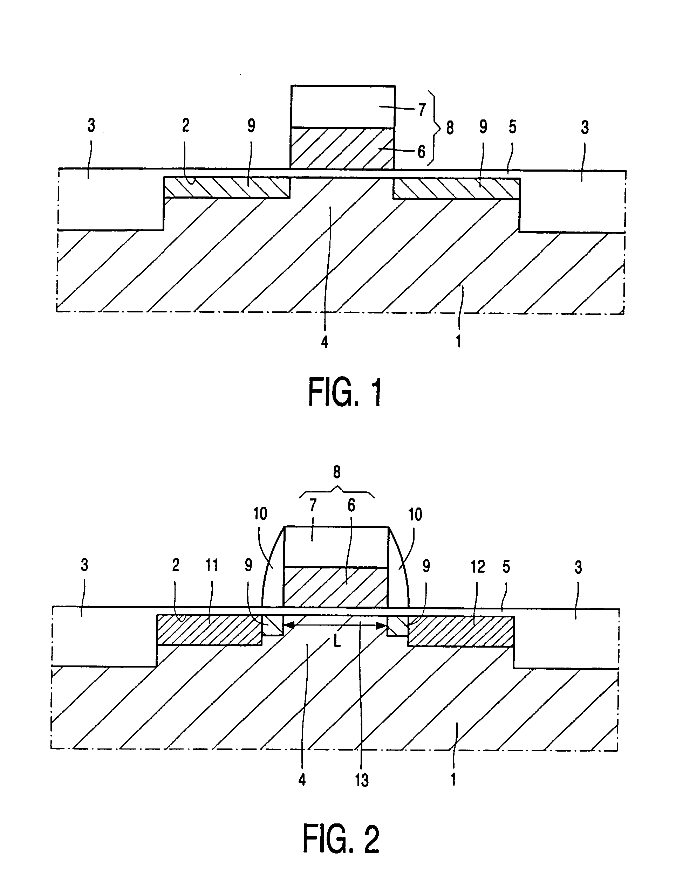

Figs. 1 to 11 show in diagrammatic cross-sectional views successive stages in the manufacture of a semiconductor device comprising a transistor, using a first method of which only figures 1-8 are in accordance with the invention.

With reference to Fig. 1, a semiconductor body 1 of a first conductivity type, in the present example a silicon body of, for instance, p-type conductivity, is provided at a surface 2 with relatively thick oxide field insulating regions 3, which are at least partly opened in the semiconductor body 1 and which define an active region 4 in which a transistor, in the present example an n-channel MOS transistor, is to be manufactured. The thick oxide insulating regions 3 are formed in a usual way by means of LOCOS (LOCal Oxidation of Silicon) or STI (Shallow Trench Isolation), Subsequently, the surface 2 of the semiconductor body 1 is provided with a layer 5 composed of, for instance, silicon oxide, which is covered by a patterned layer 8 defining the area of a gate planned to be provided at a later stage of the process. In the present example, the patterned layer 8 is obtained by depositing a double-layer consisting of a first sub-layer 6 of, for instance, polycrystalline silicon which may be doped with a dopant such as phosphorus or possible boron, and on top thereof, a second sub-layer 7 composed of, for instance, silicon nitride, and by patterning the double-layer for instance in a usual lithographic way Instead of silicon nitride, any other suitable material such as, for instance, aluminum oxide or a combination of materials can be used. Instead of polycrystalline silicon, amorphous silicon or polycrystalline SiₓGe₁₋ₓmay be used, with x representing the faction of silicon lying in the range between 0 and 1. It is to be noted, that the patterned layer may be a single layer as well, composed of polycrystalline silicon, amorphous silicon or polycrystalline SiₓGe₁₋ₓ, or any other suitable refractory material such as, for example, silicon nitride or aluminum oxide. Furthermore, the presence of the layer 5, which may have been advantageously applied in order to protect the semiconductor body against contamination, is not necessary. After applying the patterned layer 8, source/drain extensions 9 of a second, opposite conductivity type, in the present example n-type, are formed on opposite sides of the patterned layer 8 by means of a self-aligned implantation of a relatively light dose of, for instance, phosphorus or arsenic using the patterned layer 8 together with the oxide fiel insulating regions 3 as a mask.

Subsequently, the patterned layer 8 is provided with sidewall spacers 10 e.g. in a known way, for instance, by means of deposition and an isotropic etch-back of a silicon oxide layer (Fig. 2). After formation of the sidewall spacers 10, a highly-doped source zone 11 and drain zone 12 of the second conductivity type, in the present example n-type, are formed on oppposite sides of the sidewall spacers 10 by means of a self-aligned implantation of a heavier dose of, for instance, phosphorus or arsenic using the oxide field insulating regions 3 together with the patterned layer 8 and the side wall spacers 10 as a mask. It is to be noted, that a channel 13 is provided at the surface 2 of the semiconductor body 1 having a length L over which it extends between the extended source zone 11,9 and the extended drain zone 12, 9.

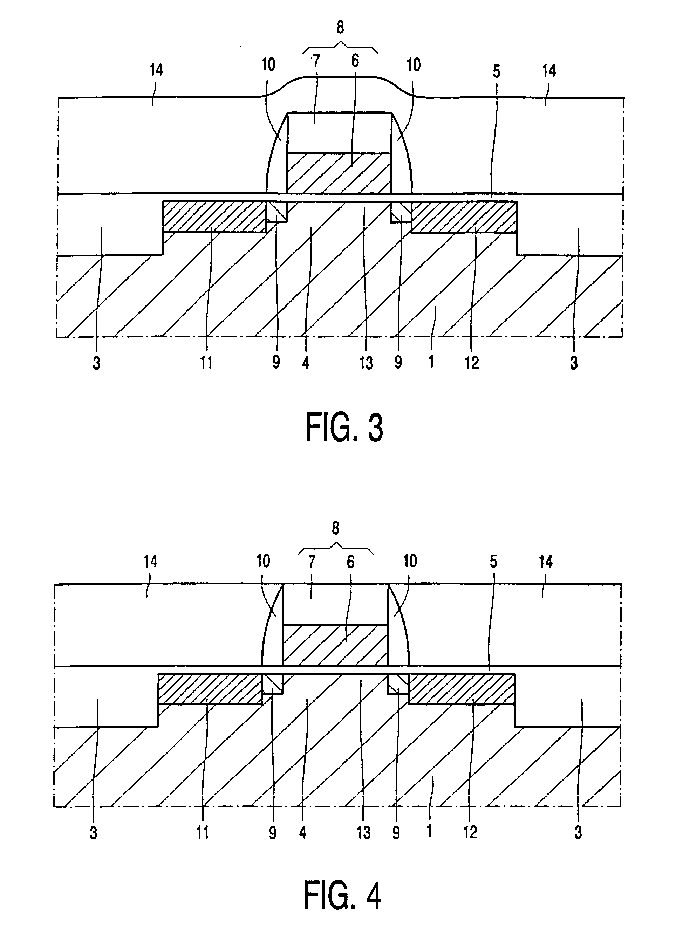

With reference to Fig. 3, a relatively tick dielectric layer 14, in the present example composed of silicon oxide, is applied in such a way, that the thickness of the dielectric layer 14 next to the patterned layer 8 is substantially equal to or larger than the height of the patterned layer 8.Obviously, other suitable electrically insulating materials such as PSG (phosphosilicate glass) or BPSG (borophosphosilicate glass) may be used as well.

Subsequently, the dielectric layer 14 is removed over a part of its thickness until the patterned layer 8 is exposed (Fig. 4). This can be accomplished by means of, for example, chemical-mechanical polishing (CMP), e.g. using a commercially available slurry. During the material removing treatment, the second sub-layer 7, in the present example composed of silicon nitride, will act as a stopping layer.

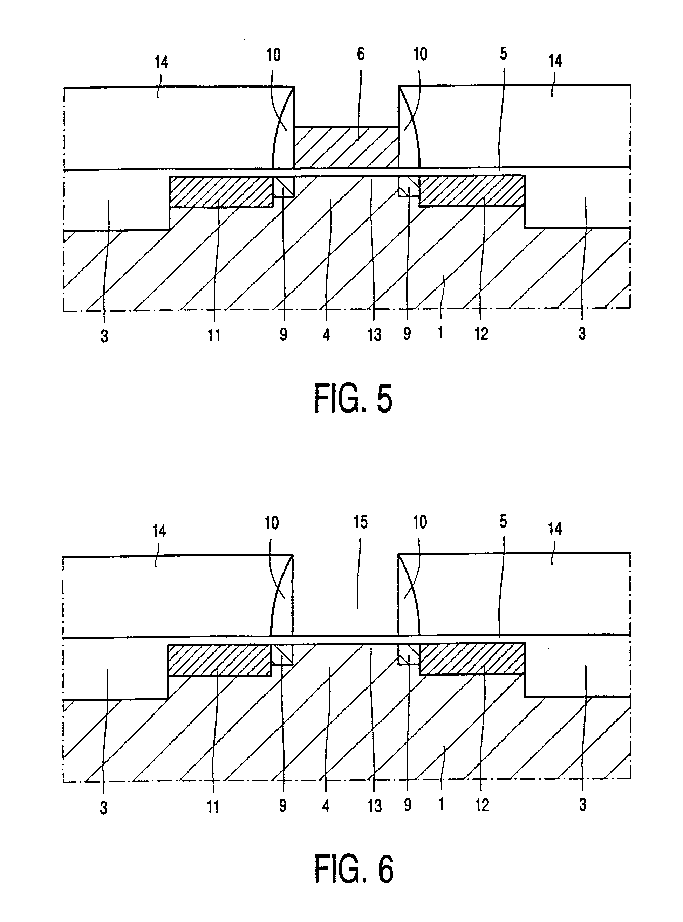

In a next step (Fig. 5), the second sub-layer 7, composed of silicon nitride in the present example, is selectively removed with respect to the dielectric layer 14 and the sidewall spacers 10, both composed of silicon oxide in the present example, by means of, for instance, wet etching using a mixture of hot phosphoric acid and sulphuric acid.

With reference to Fig. 6, the first sub-layer 6 and the layer 5 are removed in two separate etching steps. The first sub-layer 6, in the present example composed of polycrystalline silicon, can be selectively removed by means of wet etching using, for instance, a hot KOH soludon or by means of plasma etching with, for instance, a HBr/Cl₂ mixture. The layer 5, in the present example composed of silicon oxide, can be removed by means of a dip-etch using HF. In this way, the dielectric layer 14 is provided with an opening 15 at the area of the planned gate.

It is to be noted that the dielectric layer 14 provided with the opening 15 may also be obtained by depositing the dielectric later 14 and subsequently etching the dielectric layer 14 using a mask exposing the area of the planned gate. In this way, the self-aligned implantation of the extended source zone 11,9 and the extended drain zone 12,9 would have to be carried out after formation of the gate. The gate will subsequently be subjected to temperatures as high as 1000 °C, which are needed to electrically activate the as-implanted atoms and to repair the implantation damage to the lattice of the semiconductor body 1. Exposure of the gate to such high temperatures imposes serious constraints on the choice of process-compatible gate materials.

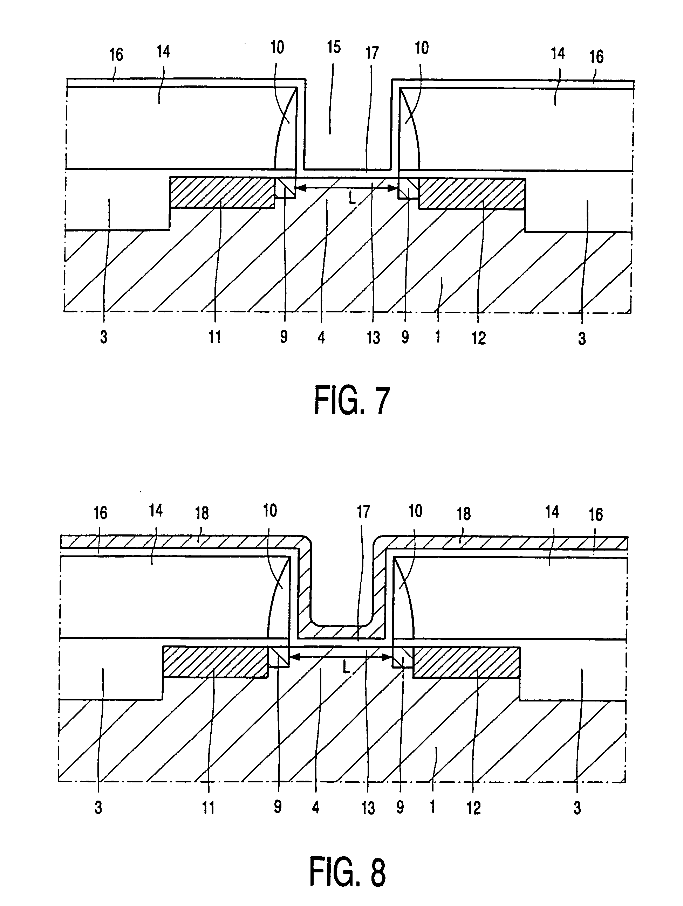

As shown in Fig. 7, an insulating layer 16 is provided on all exposed surfaces, providing a gate dielectric 17 of the MOS transistor. The insulating layer 16 may be composed of silicon oxide, however, a dielectric material with a dielectric constant higher than that of silicon oxide, such as tantalum oxide, aluminum oxide or silicon nitride may be more favorable. If silicon oxide is to be applied for the gate dielectric 17, it may be obtained by means of, for instance, chemical vapor deposition or thermal oxidation of silicon. The high dielectric constant materials tantalum oxide, aluminum oxide and silicon nitride can be applied, for example, by means of chemical vapor deposition (CVD).

With reference to Fig. 8, a first conductive layer 18 is applied to the insulating layer 16 in a usual way, which first conductive layer18 is relatively thin compared to the width of the opining 15 shown in Fig. 7. For example, in the case of a length L of the channel 13 of about 100 nm, the width of the opening 15 will be about 100 nm, whereas the thickness of the first conductive layer 18 will be in the range between about 15 and 40 nm. Moreover, in the case of a length L of the channel 13 of about 250 nm, the width of the opening 15 will be about 250 nm, whereas the thickness of the first conductive layer 18 will be in the range between about 40 and 100 nm.

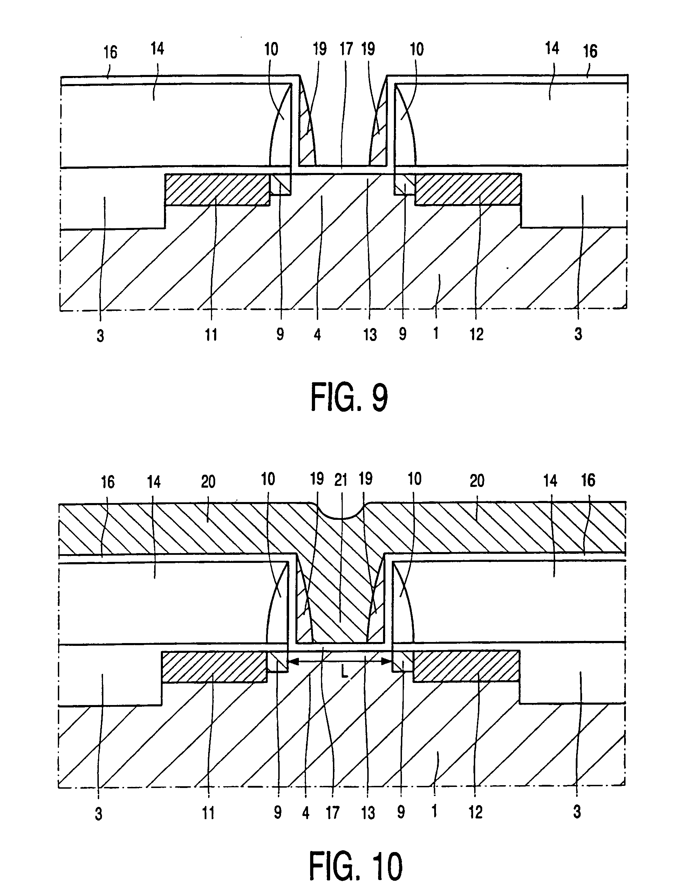

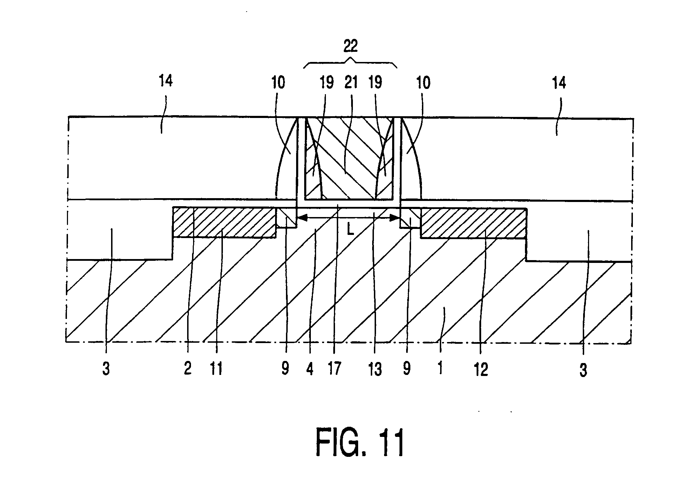

The first conductive layer 18 is then anisotropically etched (Fig. 9), forming side end portions 19 of a gate 22 to be finally formed (see Fig. 11). The anisotropic etching treatment is continued until the gate dielectric 17 at the area of a central portion 21 of the gate 22 is exposed, which central portion 21 is provided in a next step (see Fig. 10). Alternatively, the first conductive layer 18 may be subjected to an anisotropic etching treatment, until the gate dielectric 17 at the area of the central portion 21 has been approached up to about 10 nm, after which the actual exposure of the gate dielectric 17 is accomplished by means of an isotropic wet etching treatment.

With reference to Fig. 10, a second conductive layer 20 is applied in a usual way, thereby filling the opening 15 and providing the central portion 21, which central portion 21 is enclosed by the side end portions 19. The central portion 21 and the side end portions 19 of the gate 22 are in contact with the gate dielectric 17 and jointly establish a work function of the gate which varies across the length L of the channel 13, which channel 13 extends between the extended source zone 11,9 and the extended drain zone 12,9. In the present example, the work function of the side end portions 19 is varied relative to the work function of the central portion 21 in order to compensate for a threshold voltage reduction owing to short-channel effects. In case of an n-channel MOS transistor, this is achieved by applying the first conductive layer 18 with a Fermi level lower than that of the second conductive layer 20. It is understood by those skilled in the art that the first conductive layer 18 should be applied with a Fermi level higher than that of the second conductive layer 20 is order to obtain a similar effect for a p-channel MOS transistor. It will be evident that several combinations of conductive materials, which may be selected from, for example, metals and semiconductor materials, are possible for the first conductive layer and the second conductive layer, each one of these combinations usually satisfying only one of the above-mentioned conditions, that is to say the condition for the n-channel MOS transistor of the condition for the p-channel MOS transistor. It is therefore advantageous to apply the second conductive layer 20 as a layer of a semiconductor material of the second conductivity type, namely the n-type in the case of an n-channel MOS transistor and the p-type in the case of a p-channel MOS transistor, the semiconductor material having a band gap, and to apply the first conductive layer 18 as a layer of a conductive material having a Fermi level positioned approximately halfway the band gap of the semiconductor material of the second conductive layer-20. This enables both a p-channel MOS transistor and an n-channel MOS transistor to be manufactured using one common first conductive layer 18, which reduces the number of masks required for the manufacture of a semiconductor device comprising an n-channel MOS transistor as well as a p-ehannel MOS transistor by two. In this respect, it is advantageous to apply polycrystalline silicon or amorphous silicon as the semiconductor material of the second conductive layer 20 and a material selected from the group comprising titanium nitride (TiN), tungsten (W) and tantalum disilicide (TaSi₂) as the conductive material of the first conductive layer 18. Anisotropic etching of titanium nitride may be carried out in for example, a BCI, plasma, whereas anisotropic etching of tungsten and tantalum disilicide may be carried out in for example, an SF₆ plasma. Obviously, other combinations of a semiconductor material and a conductive material are possible as well, provided the Fermi level of the conductive material is positioned approximately halfway the band gap of the semiconductor material. Doping of the semiconductor material may be carried out during deposition (in-situ) or after deposition.

With reference to Fig. 11, the second conductive layer 20 is shaped so as to complete the gate 22 of the MOS transistor. This can be achieved by means of, for example, etching using an oversized mask. In that case the conductive material of the gate 22 stretches out over the dielectric layer 14, which is coated with the insulating layer 16, to beyond the opening 15 shown in Fig. 7. It is however preferred to use a maskless process to remove the second conductive layer 20 until the insulating layer 16 is exposed, thereby forming the gate 22 which is openinged in the dielectric layer 14. An additional maskless removal of the insulating layer 16, the result of which is shown in Fig. 11 is not required, but can be beneficial in case the insulating layer 16 includes a high dielectric constant material. Maskless removal of either the second conductive layer 20 or the second conductive layer 20 and the insulating layer 16 is accomplished by means of, for example, chemical-mechanical polishing (CMP) using a commercially available slurry.

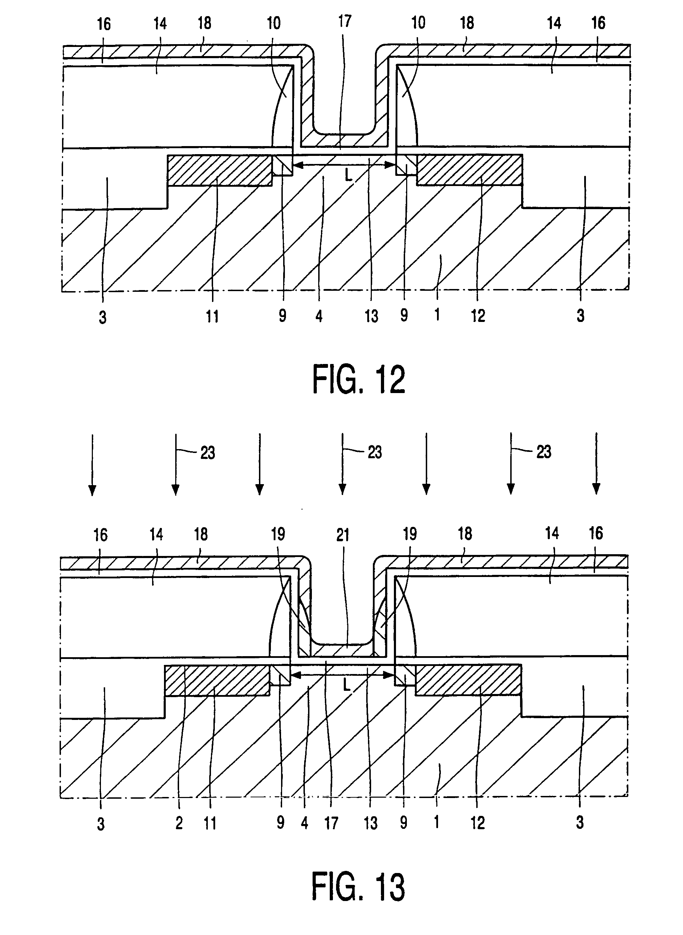

Figs. 12 to 15 show in diagrammatic cross-sectional views successive stages in the manufacture of a semi conductor device comprising a transistor, using an embodiment of the method in accordance with the invention.

Fig, 12 shows the same situation as Fig. 8 except that the first conductive layer 18 is now applied as a layer of a semiconductor material, in the present example polycrystalline silicon, which layer of semiconductor material is relatively thin compared to the width of the opening 15 shown in Fig. 7. For example, in the case of a length L of the channel 13 of about 100 nm, the width of the opening 15 will be about 100 nm, whereas the thickness of the first conductive layer 18 will be in the orange between, about 15 and 40 mn. Moreover, in the case of a length L of the channel 13 of about 250 nm, the width of the opening 15 will be about 250 nm, whereas the thickness of the first conductive layer 18 will be in the range between about 40 and 100 nm. Amorphous silicon or polycrystalline SiₓGe₁₋ₓ may be used instead of polycrystalline silicon, with x representing the fraction of silicon lying between 0 and 1. Instead of one of the above-mentioned semiconductor materials, which all comprise silicon, a semiconductor material such as, for example, SiC or GaAs may be used. The first conductive layer 18 may be applied in a usual way by means of, for example, chemical vapor deposition.

In a next step (Fig. 13), the first conductive layer 18, in the present example a layer of polycrystalline silicon, is implanted with impurities of the second conductivity type in the present example a type impurities such as, for example, phosphorus (P) ions or arsenic (As) ions, substantially perpendicularly to the surface 2 of the semiconductor body 1 as depicted by arrows 23. It is to be noted that the above-mentioned implantation consists of an actual implantation of the atoms into the first conductive layer 18 followed by a short anneal or so-called drive-in step to electrically activate the as implanted atoms. For example, phosphorus may be implanted at an energy lying in the range of about 1 to 15 keV and a dose of about 3.10¹³ to 3.10¹⁵ atoms/cm², and it may be annealed at a temperature of, for example, about 950°C for a time of, for example, about 10 seconds. On the other hand, arsenic may be implanted at an energy lying in the range of about 1. to 10 keV and a dose of about 3.10¹³ to 3.10¹⁵ atoms/cm² and it may be annealed at a temperature of, for example, about 950°C for a time of, for example, about 10 seconds. By carrying out the implantation substantially perpendicularly to the surface 2 of the semiconductor body 1, a central portion 21 and side end portions 19 positioned along either side of the central portion 21 are formed, which central portion 21 is relatively heavily doped compared to the side end portions 19. By an appropriate selection of implantation conditions it is possible to dope the central portion of the gate with impurities while keeping the side end portions of the gate at least substantially free from impurities. The central portion 21 and the side end portions 19, which are part of a gate 22 to be finally formed (see Fig, 15), are in contact with the gate dielectric 17 and jointly establish a work function of the gate 22 varying across the length L of the channel 13, which channel 13 extends between the extended source zone 11,9 and the extended drain zone. 12,9. In the present example, the work function of the side end portions 19 is varied relative to the work function of the central portion 21 in order to compensate for a threshold voltage reduction owing to short-channel effects. It is understood by those skilled in the art that boron (B) ions may be implanted in order to achieve a similar effect for a p-channel MOS transistor. Boron may be implanted at an energy lying in the range of about 0.5 to 5 keV and a dose of, for example, about 3.10¹³ to 3.10¹⁵ atoms/cm² and it may be annealed at a temperature of about 950°C. for a time of, for example, about 10 seconds.

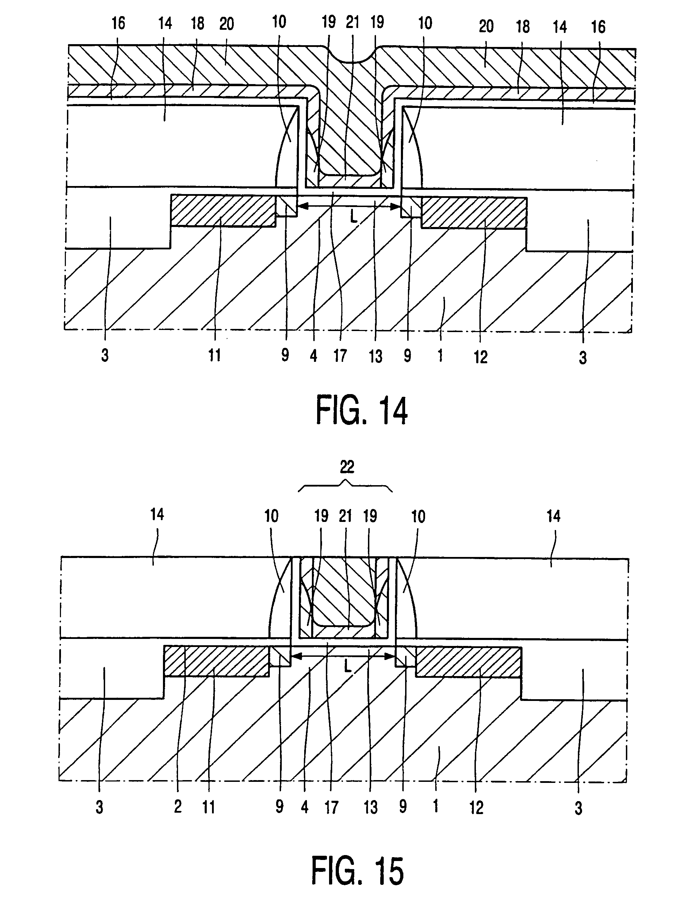

With reference to Fig. 14, a second conducive layer 20 is applied in a usual way, thereby filing the opening 15. The second conductive layer 20 may be applied as a layer of a semiconductor material of the second conductivity type, in the present example of the n-type. Polycrystalline silicon, amorphous silicon or polycrystalline SiₓGeₗ₋ₓ may be used as the semiconductor material, with x representing the fraction of silicon lying between 0 and 1. Instead of one of the above-mentioned semiconductor materials, which all comprise silicon, a semiconductor material such as, for example, SiC or GaAs, may be used. Doping of the semiconductor material may be carried out during deposition (in-situ) or after deposition. The second conductive layer 20 may, however, also be applied as a layer comprising a metal such as aluminum, tungsten" copper or molybdenum, or a combination of metals. This enables both a p-channel MOS transistor and an n-channel MOS transistor can be manufactured using one common second conductive layer 20, which reduces the number of masks required for the manufacture of a semiconductor device comprising an n-channel MOS transistor as well as a p-channel MOS transistor by two. If a metal or a combination of metals is used, the second conductive layer 20 is advantageously applied as a double layer consisting of a layer comprising the metal or the combination of metals on top of a layer acting as adhesion layer nd/or barrier layer. In this respect Ti may be applied as adhesion layer and TiN or TiW as barrier layer. It is clear that the above-mentioned implantation anneal imposes no constraints on the choice of materials for the second conductive layer 20, as this layer is applied after the implantation.

In a next step (Fig. 15), the first conductive layer 18 and the second conductive layer 20 are shaped so as to complete the gate 22 of the MOS transistor. This can be done by means of, for example, etching using an oversized mask. In that case the conductive material of the gate 22 stretches out over the dielectric layer 14, which is coated with the insulating layer 16, to beyond the opening 15 shown in Fig. 7. It is preferred, however, to use a maskless process to remove the first conductive layer 18 and the second conductive layer 20 until the insulating layer 16 is exposed, thereby forming the gate 22 which is openinged in the dielectric layer 14. An additional maskless removal of the insulating layer 16, the result of which is shown in Fig. 15, is not required, but can be beneficial in case the insulating layer 16 includes a high dielectric constant material. Maskless removal of either the first conductive layer 18 and the second conductive layer 20 or the first conductive layer 18, the second conductive layer 20 and the insulating layer 16 is accomplished by means of, for example, chemical-mechanical polishing (CMP) using a commercially available slurry.

It will be apparent that the methods described above are not limited to the examples described above, but that many variations are possible to those skilled in the art. The side end portions of the gate, which are applied as sidewall spacers in the first method described above with respect to Figures 1-8, may each be built up from several sub-sidewal spacers, which jointly provide a work function varying across the side end portions. For the benefit of a p-channel transistor, the first conductive layer may also be applied as a layer of polycrystalline SiₓGe₁₋ₓ providing the central portion as well as the side end portions of the gate which side end portions contain a relatively high fraction of germaniun compared to the central portion. It is noted that, prior to the application of the first conducive layer and the second conductive layer, impurities may be introduced via the opening into the semiconductor body by means of, for example, ion implantation so as to provide for an impurity region for e.g. punchthrough suppression and/or threshold voltage adjustment. The surface layer, which is applied to the semiconductor body before the application of the patterned layer, may form the gate dielectric of the transistor instead of the insulating layer, which is applied after the provision of the opening in the dielectric layer. In that cast, application of the insulating layer is omitted. Moreover, the source zone and the drain zone of the transistor can optionally be implanted without extensions. In the methods described above the active region is formed by a surface region of the original semiconductor body. Alternatively, the active region may represent a conventional p or n well, which is obtained by locally doping the original semiconductor body in a region adjoining its surface with a doping concentration suitable for providing an n-channel or p-channel transistor.

## Claims

1. A method of manufacturing a semiconductor device comprising a semiconductor body (1) which is provided at a surface (2) with an active region (4) of a first conductivity type, which active region (4) is provided with a transistor having a gate (22) insulated from a channel provided at the surface of the semiconductor body by a gate dielectric (17), the channel having a length (L) over which it extends between a source zone (11, 9) and a drain zone (12, 9) of a second conductivity type provided in the semiconductor body (1), the gate (22) comprising a central portion (21) and side end portions (19) positioned along either side of the central portion, which central portion (21) and side end portions (19) are in contact with the gate dielectric and jointly establish a work function of the gate (22) varying across the length of the channel, wherein, after the definition of the active region (4), a dielectric layer (14) is applied which is provided with an opening (15) at the area of the gate (22) planned to be provided at a later stage, after which a first conductive layer (18) and a second conductive layer (20) are applied, the first conductive layer (18), being relatively thin compared to the width of the opening (15), which first conductive layer (18) and second conductive layer (20) jointly form the gate (22) of the transistor and fill the opening (15) in the dielectric layer, wherein a layer of a semiconductor material is applied as the first conductive layer (18), which layer, for lateral grading of the work function of the gate, is implanted (23) with impurities of the second conductivity type substantially perpendicularly to the surface (2) of the semiconductor body (1), thereby providing the central portion (21) and the side end portions (19) of the gate (22), which central portion (21) is relatively heavily doped compared to the side end portions (19), after which the second conductive layer (20) is applied thus filling the opening (15).

2. A method as claimed in claim 1, **characterized in that**, prior to the application of the dielectric layer (14), a patterned layer (6, 7) is applied at the area of the planned gate, after which the source zone (11, 9) and the drain zone (12, 9) of the second conductivity type are formed in the semiconductor body (1) while using the patterned layer (6, 7) as a mask, after which the dielectric layer (14) is provided in such a way, that the thickness of the dielectric layer next to the patterned layer is substantially equal to or larger than the height of the patterned layer, which dielectric layer (14) is removed over part of its thickness by means of a material removing treatment until the patterned layer (6, 7) is exposed, which patterned layer is removed, thereby forming the opening (15) in the dielectric layer (14) at the area of the planned gate (22).

3. A method as claimed in claim 1 or 2 , wherein after the dielectric layer (14) is applied which is provided with the opening (15) at the area of the gate (22) planned to be provided at a later stage, in the opening (15) an insulating layer (16) is applied, providing the gate dielectric (17) of the transistor.

4. A method as claimed in any one of the claims 1-3, **characterized in that** the work function of the side end portions (19) of the gate (22) is varied relative to the work function of the central portion (21) of the gate (22) so as to compensate for a threshold voltage reduction owing to short-channel effects.

5. A method as claimed in claim 1, wherein in case of a p-channel transistor, a SiₓGe₁₋ₓ layer provides the central portion as well as the side end portions, which side end portions contain a relatively high fraction of germanium compared to the central portion.

6. A method as claimed in claim 1, **characterized in that** a further layer of a semiconductor material of the second conductivity type is applied as the second conductive layer (20).

7. A method as claimed in claim 6, **characterized in that** the further layer of the semiconductor material is applied by depositing a layer comprising silicon.

8. A method as claimed in claim 1 as far as dependent on claims 2 and 4, **characterized in that** a layer comprising a metal is applied as the second conductive layer (20).

9. A method as claimed in claim 8, **characterized in that** the layer comprising the metal is applied as a double-layer consisting of a layer comprising the metal on top of a layer acting as adhesion and/or barrier layer.

10. A method as claimed in claim 8 or 9, **characterized in that** the metal is selected from the group comprising aluminum, tungsten, copper, and molybdenum.

11. A method as claimed in any one of claims 1 or 6 through 10, **characterized in that** the layer of the semiconductor material is applied by depositing a layer comprising silicon.

## Patentansprüche

1. Verfahren zum Herstellen eines Halbleitergeräts, welches einen Halbleiterkörper (1) aufweist, welcher an einer Oberfläche (2) mit einem aktiven Bereich (4) eines ersten Leitfähigkeitstyps bereitgestellt ist, wobei der aktive Bereich (4) mit einem Transistor bereitgestellt ist, welcher ein Gate (22) isoliert von einem Kanal hat, welcher bei der Oberfläche des Halbleiterkörpers mittels eines Gate-Dielektrikums (17) bereitgestellt ist, wobei der Kanal eine Länge (L) hat, über welche er sich zwischen einer Source-Zone (11, 9) und einer Drain-Zone (12, 9) eines zweiten Leitfähigkeitstyps erstreckt, welche in dem Halbleiterkörper (1) bereitgestellt sind, wobei das Gate (22) einen zentralen Abschnitt (21) und Seitenendabschnitte (19), welche entlang beider Seiten des Zentralabschnitts positioniert sind, aufweist, wobei der zentrale Abschnitt (21) und die Seitenendabschnitte (19) in Kontakt mit dem Gate-Dielektrikum sind und zusammenwirkend eine Austrittsarbeit des Gates (22) etablieren, welche über die Länge des Kanals variiert, wobei nach der Definition des aktiven Bereichs (4) eine dielektrische Schicht (14) aufgebracht wird, welche mit einer Öffnung (15) bei der Fläche des Gates (22) bereitgestellt ist, welches geplant ist, zu einem späteren Stadium bereitgestellt zu werden, wonach eine erste leitfähige Schicht (18) und eine zweite leitfähige Schicht (20) aufgebracht werden, wobei die erste leitfähige Schicht (18) relativ dünn verglichen mit der Breite der Öffnung (15) ist, wobei die erste leitfähige Schicht (18) und die zweite leitfähige Schicht (20) zusammenwirkend das Gate (22) des Transistors bilden und die Öffnung (15) in der dielektrischen Schicht füllen, wobei eine Schicht eines Halbleitermaterials als die erste leitfähige Schicht (18) angewendet wird, welche Schicht für eine laterale Abstufung der Austrittsarbeit des Gates mit Verunreinigungen des zweiten Leitfähigkeitstyps im Wesentlichen senkrecht zu der Oberfläche (2) des Halbleiterkörpers (1) implantiert ist, um **dadurch** den zentralen Abschnitt (21) und die Seitenendabschnitte (19) des Gates (22) bereitzustellen, welcher zentrale Abschnitt (21) relativ hoch dotiert ist verglichen mit den Seitenendabschnitten (19), wonach die zweite leitfähige Schicht (20) aufgebracht wird, um somit die Öffnung (15) zu füllen.

2. Verfahren gemäß Anspruch 1, **dadurch gekennzeichnet, dass** vor dem Aufbringen der dielektrischen Schicht (14) eine strukturierte Schicht (6, 7) bei der Fläche des geplanten Gates aufgebracht wird, wonach die Source-Zone (11, 9) und die Drain-Zone (12, 9) des zweiten Leitfähigkeitstyps in dem Halbleiterkörper (1) gebildet werden, während die strukturierte Schicht (6, 7) als eine Maske benutzt wird, wonach die dielektrische Schicht (14) in derartiger Weise bereitgestellt wird, dass die Dicke der dielektrischen Schicht benachbart der strukturierten Schicht im Wesentlichen gleich ist wie oder größer ist als die Höhe der strukturierten Schicht, welche dielektrische Schicht (14) über einen Teil ihrer Dicke mittels einer Materialentfemungsbehandlung entfernt wird, bis die strukturierte Schicht (6, 7) exponiert ist, welche strukturierte Schicht entfernt wird, um **dadurch** die Öffnung (15) in der dielektrischen Schicht (14) bei der Fläche des geplanten Gates (22) zu bilden.

3. Verfahren gemäß Anspruch 1 oder 2, wobei, nachdem die dielektrische Schicht (14) aufgebracht ist, welche mit der Öffnung (15) bei der Fläche des Gates (22), welches geplant ist, zu einem späteren Stadium bereitgestellt zu werden, bereitgestellt ist, in der Öffnung (15) eine isolierende Schicht (16) aufgebracht wird, bereitstellend das Gate-Dielektrikum (17) des Transistors.

4. Verfahren gemäß einem der Ansprüche 1 bis 3, **dadurch gekennzeichnet, dass** die Austrittsarbeit der Seitenendabschnitte (19) des Gates (22) relativ zu der Austrittsarbeit des zentralen Abschnitts (21) des Gates (22) variiert ist, um so eine Schwellwertspannungsverminderung aufgrund von Kurzschluss-Kanaleffekten zu kompensieren.

5. Verfahren gemäß Anspruch 1, wobei im Falle eines p-Kanal-Transistors eine SiₓGe₁₋ₓ-Schicht den zentralen Abschnitt sowie die Seitenendabschnitte bereitstellt, welche Seitenendabschnitte einen relativ hohen Anteil von Germanium verglichen mit dem zentralen Abschnitt enthalten.

6. Verfahren gemäß Anspruch 1, **dadurch gekennzeichnet, dass** eine weitere Schicht eines Halbleitermaterials des zweiten Leitfähigkeitstyps als die zweite leitfähige Schicht (20) aufgebracht wird.

7. Verfahren gemäß Anspruch 6, **dadurch gekennzeichnet, dass** die weitere Schicht des Halbleitermaterials mittels Deponierens einer Schicht, welche Silizium aufweist, aufgebracht wird.

8. Verfahren gemäß Anspruch 1, soweit abhängig von Anspruch 2 und 4, **dadurch gekennzeichnet, dass** eine Schicht, welche ein Metall aufweist, als die zweite leitfähige Schicht (20) angewendet wird.

9. Verfahren gemäß Anspruch 8, **dadurch gekennzeichnet, dass** die Schicht, welche das Metall aufweist, als eine Doppelschicht angewendet wird, welche aus einer Schicht besteht, welche das Metall oben auf einer Schicht aufweist, welche als eine Adhäsions- und/oder Barriereschicht fungiert.

10. Verfahren gemäß Anspruch 8 oder 9, **dadurch gekennzeichnet, dass** das Metall ausgewählt ist von der Gruppe, welche Aluminium, Wolfram, Kupfer und Molybdän aufweist.

11. Verfahren gemäß einem der Ansprüche 1 oder 6 bis 10, **dadurch gekennzeichnet, dass** die Schicht des Halbleitermaterials mittels eines Deponierens einer Schicht, welche Silizium aufweist, aufgebracht wird.

## Revendications

1. Procédé de fabrication d'un dispositif semi-conducteur comprenant un corps semi-conducteur (1) qui est prévu au niveau d'une surface (2) et possède une région active (4) d'un premier type de conductivité, cette région active (4) étant pourvue d'un transistor ayant une grille (22) isolée d'un canal prévu à la surface du corps semi-conducteur par un diélectrique de grille (17), le canal ayant une longueur (L) sur laquelle il s'étend entre une zone de source (11, 9) et une zone de drain (12, 9) d'un deuxième type de conductivité prévues dans le corps semi-conducteur (1), la grille (22) comprenant une partie centrale (21) et des parties terminales latérales (19) situées le long de chaque côté de la partie centrale, cette partie centrale (21) et ces parties terminales latérales (19) étant en contact avec le diélectrique de grille et établissant de manière conjointe une fonction de travail de la grille (22) qui varie d'un bout à l'autre de la longueur du canal, procédé dans lequel, après la définition de la région active (4), une couche diélectrique (14) est appliquée et pourvue d'une ouverture (15) au niveau de la zone de la grille (22) destinée à être prévue dans une étape ultérieure, après quoi une première couche conductrice (18) et une deuxième couche conductrice (20) sont appliquées, la première couche conductrice (18) étant relativement mince par comparaison avec la largeur de l'ouverture (15), ces première couche conductrice (18) et deuxième couche conductrice (20) forment de manière conjointe la grille (22) du transistor et remplissent l'ouverture (15) dans la couche diélectrique, une couche d'un matériau semi-conducteur étant appliquée en tant que première couche conductrice (18), cette couche étant, pour la variation latérale de la fonction de travail de la grille, implantée (23) avec des impuretés du deuxième type de conductivité de manière sensiblement perpendiculaire à la surface (2) du corps semi-conducteur (1), constituant ainsi la partie centrale (21) et les parties terminales latérales (19) de la grille (22), cette partie centrale (21) étant dopée de manière relativement marquée en comparaison des parties terminales latérales (19), après quoi la deuxième couche conductrice (20) est appliquée, remplissant ainsi l'ouverture (15).

2. Procédé tel que revendiqué dans la revendication 1, **caractérisé en ce que**, avant l'application de la couche diélectrique (14), une couche à motifs (6, 7) est appliquée au niveau de la zone de la grille prévue, après quoi la zone de source (11, 9) et la zone de drain (12, 9) du deuxième type de conductivité sont formées dans le corps semi-conducteur (1) tout en utilisant la couche à motifs (6, 7) en tant que masque, après quoi la couche diélectrique (14) est prévue d'une manière telle que l'épaisseur de la couche diélectrique au voisinage de la couche à motifs est sensiblement égale, ou supérieure, à la hauteur de la couche à motifs, cette couche diélectrique (14) étant éliminée sur une partie de son épaisseur au moyen d'un traitement d'élimination de matériau et jusqu'à ce que la couche à motifs (6, 7) soit exposée, cette couche à motifs étant alors éliminée, formant ainsi l'ouverture (15) dans la couche diélectrique (14) au niveau de la zone de la grille prévue (22).

3. Procédé tel que revendiqué dans la revendication 1 ou 2, dans lequel, après que la couche diélectrique (14) a été appliquée en étant pourvue de l'ouverture (15) au niveau de la zone de la grille (22) destinée à être prévue dans une étape ultérieure, une couche isolante (16) est appliquée dans l'ouverture (15), fournissant ainsi le diélectrique de grille (17) du transistor.

4. Procédé tel que revendiqué dans l'une quelconque des revendications 1 à 3, **caractérisé en ce qu'**on fait varier la fonction de travail des parties terminales latérales (19) de la grille (22) par rapport à la fonction de travail de la partie centrale (21) de la grille (22) de manière à compenser la diminution de la tension de seuil due aux effets de canal court.

5. Procédé tel que revendiqué dans la revendication 1, dans lequel, dans le cas d'un transistor à canal p, une couche SiₓGe₁₋ₓ fournit la partie centrale aussi bien que les parties terminales latérales, ces parties terminales latérales contenant une fraction relativement élevée de germanium en comparaison de la partie centrale.

6. Procédé tel que revendiqué dans la revendication 1, **caractérisé en ce qu'**une couche supplémentaire en un matériau semi-conducteur du deuxième type de conductivité est appliquée en tant que deuxième couche conductrice (20).

7. Procédé tel que revendiqué dans la revendication 6, **caractérisé en ce que** la couche supplémentaire de matériau semi-conducteur est appliquée par dépôt d'une couche comprenant du silicium.

8. Procédé tel que revendiqué dans la revendication 1 ainsi que dépendant des revendications 2 et 4, **caractérisé en ce qu'**une couche comprenant un métal est appliquée en tant que deuxième couche conductrice (20).

9. Procédé tel que revendiqué dans la revendication 8, **caractérisé en ce que** la couche comprenant le métal est appliquée en tant que couche double consistant en une couche comprenant le métal au-dessus d'une couche agissant en tant que couche d'adhésion et/ou couche barrière.

10. Procédé tel que revendiqué dans la revendication 8 ou 9, **caractérisé en ce que** le métal est choisi dans le groupe comprenant l'aluminium, le tungstène, le cuivre et le molybdène.

11. Procédé tel que revendiqué dans l'une quelconque des revendications 1 ou 6 à 10, **caractérisé en ce que** la couche de matériau semi-conducteur est appliquée par dépôt d'une couche comprenant du silicium.
